# EUROPEAN PATENT SPECIFICATION

(11) **EP 2 495 491 B1**
(45) Date of publication and mention of the grant of the patent: **08.07.2015**
(21) Application number: 12157942.9
(22) Date of filing: 02.03.2012
(51) Int. Cl.: F21S 8/02, F21V 23/00, F21V 21/02, F21Y 105/00, F21V 15/01

(54) **Illumination device**
Beleuchtungsvorrichtung
Dispositif d'illumination

(30) Priority: 04.03.2011 JP 2011048098
(43) Date of publication of application: 05.09.2012
(73) Proprietor: Panasonic Intellectual Property Management Co., Ltd., Osaka 540-6207 (JP)
(72) Inventor: Kawachi, Hideharu, Kobe, Hyogo (JP); Miyakawa, Noboru, Moriguchi, Osaka (JP); Konishi, Hirofumi, Hirakata, Osaka (JP); Tanahashi, Osamu, Kyotanabe, Kyoto (JP)
(74) Representative: Rüger, Barthelt & Abel

(56) References cited:
- DE-A1-102010 038 252
- JP-A- 2007 173 424
- JP-A- 2007 227 181
- JP-A- 2009 129 766
- US-A1- 2013 134 866

## Description

### [Field of the Invention]

The present invention relates to an illumination device using an EL element as a light source.

### [Background Art]

An electroluminescent (EL) element is a light emitting part that is constructed by placing a light emitting layer between a positive electrode and a negative electrode so that the light emitting part is formed on a transparent substrate. When a voltage is applied between the positive and negative electrodes, the EL element emits light by excitons produced by recombination of electrons and holes injected into the light emitting layer as carriers.

EL elements are broadly divided into two groups, an organic EL element group wherein a light emitting layer is formed of an organic compound and an inorganic EL element group wherein a light emitting layer is formed of an inorganic compound. In particular, the organic EL element is capable of emitting light of high luminance with a low voltage and a variety of light emitting colors can be obtained depending on types of the organic compounds and it is also easy to be manufactured as a flat shaped light emitting panel, and therefore it recently becomes a focus of attention to be used as a light source of an illumination fixture.

In a light emitting device using the EL element of this type, there is known a construction that a circuit board for controlling a lighting of a light emitting panel using the EL element is placed beside the light emitting panel so as to be modularized (see, for example, Patent Literature 1).

### [Conventional Technique Document]

### [Patent Literature]

[Patent Literature 1] JP Heisei 10-189239A

JP 2009 129766 A discloses an EL illumination device comprising a light source part detachable with respect to an attachment part

### [Disclosure of the Invention]

### [Problems to be solved by the Invention]

However, in the light emitting device described in Patent Literature 1, since the circuit board is placed beside the light emitting panel, the light emitting panel cannot be provided in a position of the circuit board so that there occurs a non-luminous region (non-emission region). Therefore, for example, in the case where a plurality of modules are arranged side by side, a distance of a light emitting region of adjacent modules becomes long so that an illumination device having a large light emitting region cannot be assembled. On the other hand, if the circuit board is placed on a non-luminous surface side of the light emitting panel, the thickness of the module and the illumination device using the same increases, and there is a possibility of impairing an advantage as a flat plane shaped light emitting panel.

The present invention has been made to solve the problem mentioned above, and an object thereof is to provide an illumination device capable of increasing a light emitting region in a light emitting surface side with reduction of a thickness.

### [Means adapted to solve the Problem]

In order to solve the problem mentioned above, the present invention provides an illumination device that includes a light source part having a case for accommodating a light emitting panel and a wiring board placed on a non-luminous surface side of the light emitting panel, and an attachment part having a housing for accommodating a circuit board for controlling a lighting of the light emitting panel and detachably constructed to and from a back face of the light source part, wherein the case is formed to be protruded toward a side of the attachment part so as to constitute a concave wiring board accommodation part for accommodating the wiring board in the back side thereof, and wherein the housing is formed to be protruded toward a side of the light source so as to constitute a concave circuit board accommodation part for accommodating the circuit board in the back side thereof, whereby the wiring board accommodation part and the circuit board accommodation part are constructed in a manner that the wiring board and the circuit board are arranged so as not to be overlapped in a state of attaching the attachment part to the light source part so that the case of the light source part and the housing of the attachment part are fitted to each other.

In the illumination device mentioned above, it is preferable that the concave portion constructed outside of the wiring board accommodation part of the case and the circuit board accommodation part protruded toward the light source side in the housing are respectively formed in corresponding positions so as to be fitted to each other in a relation of projections and depressions.

In the illumination device mentioned above, it is preferable that the wiring board is formed in a frame shape and the circuit board is placed in a center portion of the attachment part so that the circuit board corresponds to a central opening of the frame shaped wiring board.

### [Effect of the Invention]

According to the present invention, since the wiring board and the circuit board are both placed on the non-luminous surface side of the light emitting panel, the light emitting region on the light emitting surface side can be increased. Moreover, since the wiring board and the circuit board are accommodated so as not to be overlapped, the thickness of the illumination device can be reduced to be thinner compared to a case of accommodating the boards in an overlapped state.

### [Brief Description of the Drawings]

[Fig. 1] Fig. 1 is an exploded perspective view of an illumination device according to one embodiment of the present invention.
[Fig. 2] Fig. 2 is an exploded perspective view of a light source of the illumination device seeing from a side of an attachment part.
[Fig. 3] Fig. 3 is a front view of a light emitting panel and a wiring board used in the light source of the illumination device.
[Fig. 4] Fig. 4 is an exploded perspective view of the attachment part of the illumination device seeing from an opposite side of the light source.
[Fig. 5] Fig. 5 is a perspective view of the attachment part of the illumination device seeing from the light source side.
[Figs. 6 (a) and 6(b)] Fig. 6 (a) is a side view showing a state of the light source part and the attachment part of the illumination device being separated, and Fig. 6 (b) is a side view showing a state of the light source part being attached to the attachment part.

### [Best Mode for Carrying Out the Invention]

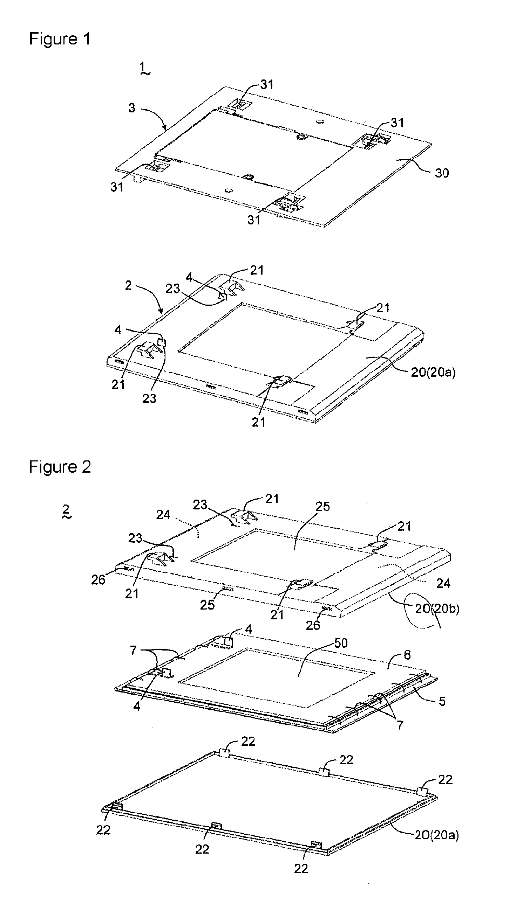

An illumination device according to one embodiment of the present invention is described below referring to Figs. 1 to 6. As shown in Fig. 1, the illumination device 1 of the present embodiment includes a light source part 2 having a case 20 adapted to accommodate a flat shaped light emitting panel using an organic EL element and an attachment part 3 having a housing 30 adapted to accommodate a circuit board for controlling a lighting of the light emitting panel. In the case 20 of the light source part 2, there is accommodated a wiring board to be described later together with the light emitting panel. Moreover, the light source part 2 includes a plurality of claw portions 21 on a surface (back side) opposing to the attachment part 3 for engaging with the attachment part 3 and terminal portions 4 for electrically connecting the wiring board and the circuit board of the attachment part 3. The terminal portions 4 are protruded on the circuit board of the light source part 2 so as to be exposed to a side of the attachment part 3 through slot portions 23 formed in the case 20. In addition, the attachment part 3 includes holding portions 31 adapted to be engaged with the claw portions 21 of the light source part 2 so that the light source part 2 can be made detachable by the holding portions 31.

As shown in Fig. 2, the light source part 2 includes the light emitting panel 5 and the wiring board 6 placed on a non-luminous surface side (upward direction in Fig. 2) of the light emitting panel 5 in addition to the case 20 mentioned above. The light emitting panel 5 and the wiring board 6 are bonded to be fixed with an acrylic double-side adhesive tape etc. containing a core material having excellent heat resistance, moisture resistance and stress relaxation properties so as to be electrically connected by performing such as ultrasonic welding of conductive wires 7.

The case 20 includes a front case 20a covering a light emitting surface side (downward direction in Fig. 2) of the light emitting panel 5 and a back case 20b covering the non-luminous surface side. The front case 20a includes a transparent rectangular flat-plate member. Alternatively, the front case 20 may be a rectangular frame shaped member having an opening face opposing to the light emitting panel 5 or a rectangular flat-plate member having at least a transparent face opposing to the light emitting panel 5. Note that, if the front case 20a is the former, it is desirable that a transparent protective cover etc. is placed over an opening position. A plurality of engagement claws 22 are protruded in the circumference of the front case 20a for engagement with the back case 20b.

The back case 20b is a can-shaped member with a bottom having an opening face opposing to the front case 20a and a surrounding portion of a surface side thereof is formed to be convex toward an opposing direction to the attachment part 3 and a concave wiring board accommodation part 24 for accommodating the wiring board 6 is formed in the back surface side thereof. Further, the back case 20b includes a concave portion 25 that includes parts other than the wiring board accommodation part 24. In other words, the wiring board accommodation part 24 is formed to have a frame shape including the concave portion 25 located in a central portion thereof.

The claw portions 21 mentioned above are formed on a surface of the wiring board accommodation part 24 opposing to a side of the attachment part 3 integrally with the back case 20b. In this example, the claw portions 21 are provided at four positions and the tip ends of the paired claw portions 21 provided in the longitudinal direction of the back case 20b are formed to be outward to each other. Further, engagement slots 26 for engagement with the engagement claws 22 of the front case 20a are provided on the circumferential side surfaces of the back case 20b. The corners connecting the circumferential side surfaces having no engagement slot 26 and the wiring board accommodation part 24 are preferably chamfered as exemplified in the figure. Thus, an outer appearance of the light source part 2 can be slimmed. It is noted that, although the shapes of the front case 20a and the back case 20b of the case 20 are optional according to applications of the illumination device 1 so as to be formed in a shape corresponding to a shape of the light emitting panel 5, a long rectangular shape as shown in the figure is used in this example. Further, as a constituent material of the case 20, for example, a plastic material such as an ABS resin, acrylic resin and polystyrene resin or a metal material such as aluminum with its surface subjected to insulation.

The light emitting panel 5 is configured in a manner that a light emitting part (not shown) is formed by laminating a positive electrode including a transparent conductive film, a light emitting layer having a light emitting function and a light-reflective negative electrode in this order on a translucent rectangular substrate and then the outside of the light emitting part is coated with a sealing material. Materials for general purpose use as the organic EL element are appropriately used as the substrate, the positive electrode, the light emitting layer, the negative electrode and the sealing material. Further, a soaking plate 50 including such as a copper plate is provided on the sealing material. In addition, since the transparent electrode material such as ITO for general purpose use as the positive electrode has a relatively low electric conductivity as a conductive material, particularly in the light emitting panel 5 that is desired to have a large area of the light emitting part, there occurs a voltage drop as a position goes away from a feeding point and there may likely occur luminance unevenness in the light emitting part. Therefore, in order to prevent a voltage drop of the ITO, a metal pattern, i.e., an auxiliary electrode is formed.

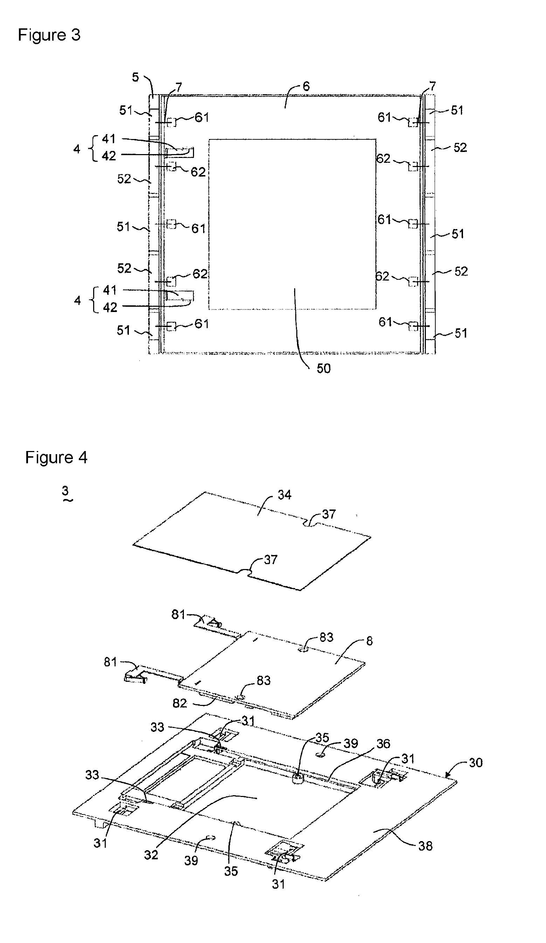

In order not to interfere with light emission to the substrate side, the auxiliary electrode is deposited by a method of sputtering and the like in a manner that a portion corresponding to a position of forming the light emitting layer is opened. Herein, the auxiliary electrode is formed in a manner that the circumferential portion of the opening position thereof is in contact with the positive electrode composed of ITO etc. and a part thereof is extended, and each of feeding electrodes 51 for taking out a positive electrode is formed as shown in Fig. 3. Also, a part of the negative electrode is subjected to patterning so as to be extended so that each of feeding electrodes 52 for taking out a negative electrode is formed. It is preferable that these feeding electrodes 51 and 52 are arranged in a manner that the same polarities are not adjacent to each other as shown in Fig. 3. That is, since the feeding electrodes 51 and 52 each having the same polarity are respectively provided in separated positions, the feeding points are dispersed so that the voltage applied to the light emitting part is uniformed, and thus the occurrence of the luminance unevenness can be suppressed.

The wiring board 6 is formed in a frame shape with its central portion opened so as to be accommodated in the wiring board accommodation part 24 using a glass fiber board formed by impregnating glass fiber cloth with epoxy resin etc. so as to be cured, for example, a base material compatible with both flame retardancy and low conductivity such as FR-4. Each of the terminal portions 4 is composed of a joint piece 41 to be jointed to the wiring board 6 and a terminal piece 42 stood from the joint piece 41. In this example, a pair of terminal portions 4 is provided in one of the circumferential portions of the wiring board 6. Moreover, a positive electrode wire and a negative electrode wire (not shown) electrically connected to the joint piece 41 of the terminal portion 4 are formed on the wiring board 6. These electrode wires are coated with an insulating material and a part thereof is exposed to a face opposite to a face opposing to the light emitting panel 5 so that land portions 61 and 62 are formed. These land portions 61 and 62 are respectively connected to the feeding electrodes 51 and 52 by conductive wires 7, wherein the feeding electrodes 51 and 52 are electrically connected to the positive and negative electrodes of the light emitting panel 5, respectively.

Regarding the feeding electrodes 51 and 52 each having the same polarity in the light emitting panel 5, the feeding electrodes 51 are not connected by the conductive wire 7 but it is preferable that the feeding electrodes 51 are electrically connected via the conductive wires 7 and the wiring board 6. In the case where the feeding electrodes 51 arranged in the circumferential portion of the light emitting panel 5 are connected to each other, since the conductive wires 7 to be connected are arch shaped, it is necessary to provide a prescribed space in the back case 20b so that the top portions of the conductive wires 7 are not brought into contact with the back case 20b. Whereas, as shown in this example, in the case where the feeding electrodes 51 and 52 are connected via the conductive wires 7 and the wiring board 6, it becomes unnecessary to arrange the conductive wires 7 in the circumferential portion. Thus, as described above, the corners of the back case 20b can be chamfered so that the light source part 2 can be slimmed.

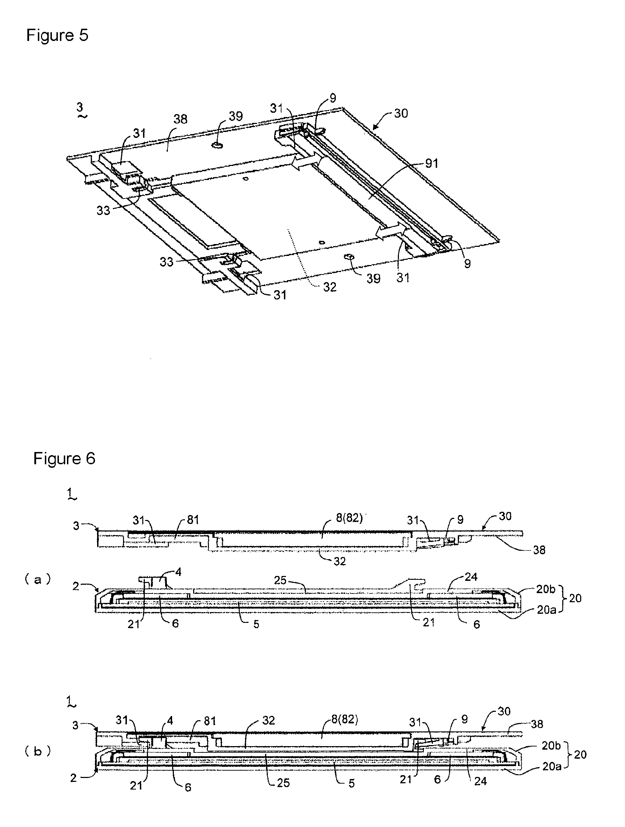

As shown in Figs. 4 and 5, the attachment part 3 includes a circuit board 8 for controlling a lighting of the light emitting panel 5 and a pair of terminal receiving portions 81 for electrically connecting between the terminal portions 4 and the circuit board 8 in addition to the housing 30 mentioned above. The housing 30 is formed to be convex toward a side of the light source 2 so as to constitute a concave circuit board accommodation portion 32 for accommodating the circuit board 8 in the back side thereof. Further, the housing 30 is provided with through grooves 33 for penetrating the terminal portions 4.

A base material similar to that of the wiring board 6 is used as the circuit board 8 and various elements 82 such as a driver for driving the lighting of the light emitting panel 5 are implemented on a surface of the rectangular shaped base material opposing to a side of the light source part 2. Further, the circuit board 8 is provided with joint portions with respect to the terminal receiving portions 81 and external power supply terminals (not shown), and these joint portions, external power supply terminals and driver etc. are electrically connected through a wiring pattern provided on the circuit board 8. The terminal receiving portions 81 are a pair of metal pieces each bent in a L character shape, and one end thereof is connected to the circuit board 8 and the other end is stood toward a side of the light source 2 so that the stood pieces are formed to be blade spring shaped so as to press the terminal portions 4 (see Fig. 1) inserted through the through grooves 33. Thus, the electrical connection between the terminal receiving portions 81 and the terminal portions 4 can be ensured. In addition, the terminal receiving portions 81 may be constructed to give a click feeling when connected to the terminal portions 4. The circuit board 8 and the terminal receiving portions 81 are covered with an insulating plate 34 from the opposite side of the surface opposing to the light source part 2 so as to be protected from external physical and electrical effects.

The circuit board accommodation part 32 is formed to be positioned in the center of the attachment part 3 so as to be fitted to the concave portion 25 of the back case 20b. Screw portions 35 are provided in the circuit board accommodation part 32. A holding frame 36 is provided on the circumference of the circuit board accommodation part 32. This holding frame 36 together with the screw portions 35 holds the circuit board 8 to be retained in a floating state so that the various elements 82 such as a driver implemented on the circuit board 8 is kept from contacting a bottom surface of the circuit board accommodation part 32. In the circuit board 8, screw holes 83 are formed at positions corresponding to the screw portions 35 of the circuit board accommodation part 32, and notches 37 are formed in the insulating plate 34. By inserting screws (not shown) through the notches 37, screw holes 83 and screw portions 35, the circuit board 8 and the insulating plate 34 are fixed to the housing 30. Herein, the screw portions 35 and the holding frame 36 hold the circuit board 8 in a position such that the surface (back face) of the circuit board 8 having no various elements 82 implemented thereon is lowered by a thickness of the insulating plate 34 than the circumferential portion 38 of the circuit board accommodation part 32. Therefore, the insulating plate 34 and the circumferential portion 38 constitute a smooth surface without a step (see Fig. 1) in a state that the insulating plate 34 is being fixed to the housing 30. Hence, when the attachment part 3 is attached to an attachment surface such as a wall surface, a stable execution can be performed without rattling. In addition, fixing holes 39 are provided in the circumferential portion 38 for inserting fixing members (not shown) for fixing the attachment part 3 to an attachment surface such as a wall surface.

As shown in Fig. 5, the holding portions 31 are provided on the surface of the housing 30 opposing to the light source part 2. The holding portions 31 are provided at positions corresponding to the claw portions 21 of the light source part 2 (see Fig. 1) and the holding portions 31 corresponding to at least two positions of the claw portions 21 are constructed to be slidable so as to be biased inward by a biasing mechanism 9 such as a spring. The slidable holding portions 31 are preferably connected by a sliding piece 91 as exemplified in the figure. Thus, when one of the holding portions 31 is slid, since the other holding portion 31 connected thereto by the sliding piece 91 is also slid together, a work of removing the light source part 2 from the attachment part 3 can be facilitated.

Next, a replacement work procedure of the light source part 2 of the illumination device 1 is described below referring to Figs. 6 (a) and (b). Note that a construction of the illumination device 1 is performed in a manner that the attachment part 3 is previously fixed to a wall surface, a ceiling or an attachment surface (not shown) of the housing constituting an illumination fixture main body. First, as shown in Fig. 6(a), the light source part 2 is opposed to the attachment part 3 in a manner that the terminal portions 4 and the terminal receiving portions 81 are located in the same direction. Then, as shown in Fig. 6(b), the light source part 2 is attached to the attachment part 3. At this time, the claw portions 21 corresponding to the holding portions 31 provided in the biasing mechanism 9 are engaged with the holding portions 31 in advance so as to slide the holding portions 31 outward. Then, the other claw portions 21 are engaged with the other holding portions 31 provided with no biasing mechanism 9. Thus, the holding portions 31 engaged in advance are returned back inward by the biasing mechanism 9 and all of the claw portions 21 are engaged with the holding portions 31 so that the light source part 2 can be easily attached to the attachment part 3. At this time, since the terminal portions 4 are connected to the terminal receiving portions 81, physical attachment and electrical connection between the light source part 2 and the attachment part 3 can be simultaneously performed.

On the other hand, when the light source part 2 is detached from the attachment part 3, the light source part 20 is grasped while depressing the holding portions 31 in a side having the biasing mechanisms 9 provided therewith so that the light source part 20 is thereby slid. Then, since the engagement between the claw portions 21 and the holding portions 31 in a side having no biasing mechanism 9 provided therewith is released, by holding up the end portion of the released light source part 2, the light source part 2 can be easily detached from the attachment part 3. Moreover, in the case where a plurality of illumination devices 1 are arranged in lines, the holding portions 31 in the side having the biasing mechanisms 9 provided therewith are slid with fingers, and in the case where a plurality of illumination devices 1 are arranged in a grid-like shape, the holding portions 31 in the side having the biasing mechanisms 9 provided therewith are slid by inserting a bar shaped member into a gap thereof. Thus, the light source part 2 can be detached from the attachment part 3 similarly to the manner described above.

In the illumination device 1 of the present embodiment, the wiring board accommodation part 24 and the circuit board accommodation part 32 are arranged in a manner that the wiring board 6 and the circuit board 8 are not overlapped and that the case 20 of the light source part 2 and the housing 30 of the attachment part 3 are fitted to each other. By this configuration, since the wiring board 6 and circuit board 8 are both placed in the non-luminous surface side of the light emitting panel 5 in the attached state between the light source part 2 and the attachment part 3, the light emitting region in the light emitting surface side can be increased. Therefore, also in the case where a plurality of illumination devices 1 are arranged, the mutual light emitting panels 5 can be arranged in close proximity to each other, there can be assembled an illumination device with a large light-emitting area. Moreover, since the wiring board 6 and the circuit board 8 are accommodated in a manner that these boards are not overlapped, the thickness of the illumination device 1 can be thinner compared to a case of accommodating these boards while being overlapped.

Further, the concave portion 25 of the case 20 and the circuit board accommodation part 32 protruded to a side of the light source part 2 in the housing 30 are respectively formed in the corresponding positions so as to be fitted to each other in a projection and depression relationship. That is, the side of the case 20 of the light source part 2 is concave and the side of the housing 30 of the attachment part 3 is convex. Since the circuit board accommodation part 32 of the attachment part 3 requires an accommodation space for the various elements 82 etc. to be implemented on the circuit board 8, a protrusion amount thereof becomes larger than a protrusion amount (depth of the concave portion 25) of the wiring board accommodation part 24 of the light source part 2. Therefore, as shown in Fig. 6(b), there is formed a slight gap between the circumference 38 of the circuit board accommodation part 32 and the wiring board accommodation part 24. In this gap, screw heads of screws for fixing the attachment part 3 to the attachment surface etc. and external feeding wires for feeding electric power to the circuit board 8 etc. can be accommodated.

Moreover, the wiring board 6 is formed in a frame shape and the circuit board 8 is located in the central portion of the attachment part 3 so as to correspond to the central opening of the frame shaped wiring board 6. With this configuration, the land portions 61 and 62 can be provided in close proximity to the feeding electrodes 51 and 52 of the light emitting panel 5. Therefore, since the connection distance of each of the conductive wires 7 can be reduced, the height of the top portion of the conductive wire 7 can be suppressed to be low so that the case 20 can be reduced in thickness, and further consumption amount of the conductive wire 7 can be reduced. Moreover, since the rectangular shaped board can be used for the circuit board 8, the various elements 82 such as a driver etc. implemented on the circuit board 8 can be concentratedly installed without being dispersed.

Further, since the illumination device 1 has the light source part 2 including the light emitting panel 5 and the attachment part 3 including the circuit board 8 as separated bodies, when there occurs, for example, a breakdown of the light emitting panel 5 or a failure of lighting due to a life of the element etc., a user may replace only the light source part 2. Moreover, since the light source part 2 does not include the circuit board 8 and the like, it may be manufacture at a lower cost compared to a module containing the same.

In addition, the present invention is not limited to the above embodiment and various changes and modifications thereof can be performed so long as the wiring board accommodation part 24 and the circuit board accommodation part 32 are arranged in a manner that the wiring board 6 and the circuit board 8 are not overlapped and that the case 20 and the housing 30 are fitted to each other. For example, in the above embodiment, although the circuit board accommodation part 32 is adapted to be fitted to the concave portion 25 of the case 20, there may be arranged in a manner that the wiring board accommodation part 24 and the circuit board accommodation part 32 are mutually rectangular shaped and they are arranged in a staggered configuration so as to share a prescribed space. Also, there may be configured that the circuit board accommodation part 32 is formed in a frame shape so that the wiring board accommodation part 24 is interposed to be fitted to the circuit board accommodation part 32.

### [Description of Reference Numerals]

- 1: Illumination device
- 2: Light source part
- 20: Case
- 24: Wiring board accommodation part
- 25: Concave portion
- 3: Attachment part
- 30: Housing
- 32: Circuit board accommodation part
- 5: Light emitting panel
- 6: Wiring board
- 8: Circuit board

## Claims

1. An illumination device (1) comprising:
a light source part (2) having a case (20) for accommodating a flat shaped light emitting panel (5) and a wiring board (6) placed on a non-luminous surface side of the light emitting panel; and
an attachment part (3) having a housing (30) for accommodating a circuit board (8) for controlling a lighting of the light emitting panel and adapted to be detachable with respect to a back face of the light source part, wherein
the case is formed to be protruded toward a side of the attachment part so as to constitute a concave wiring board accommodation part (24) for accommodating the wiring board in the back side thereof, wherein
the housing is formed to be protruded toward a side of the light source so as to constitute a concave circuit board accommodation part for accommodating the circuit board in the back side thereof, and wherein
the wiring board accommodation part and the circuit board accommodation part are configured in a manner that, the wiring board and the circuit board are arranged so as not to be overlapped to each other in a state that the attachment part and the light source part are attached so that the case of the light source part and the housing of the attachment part are fitted to each other.

2. The illumination device according to claim 1, wherein a concave portion constructed outside of the wiring board accommodation part in the case and the circuit board accommodation part protruded toward the light source side in the housing are respectively formed in corresponding positions so as to be fitted to each other in a relation of projections and depressions.

3. The illumination device according to claim 2, wherein the wiring board is formed in a frame shape and the circuit board is placed in a center portion of the attachment part so that the circuit board corresponds to a central opening of the frame shaped wiring board.

## Patentansprüche

1. Beleuchtungsvorrichtung, die aufweist:
Ein Lichtquellenteil (2) mit einem Kasten (20) zur Aufnahme eines flachgestalteten lichtemittierenden Panels (5) und einer Verdrahtungsplatine (6), die auf einer nicht leuchtenden Oberflächenseite des lichtemittierenden Panels angeordnet ist; und
ein Befestigungsteil (3) mit einem Gehäuse (30) zur Aufnahme einer Leiterplatte (8) zum Steuern des Leuchtens des lichtemittierenden Panels und dazu eingerichtet, von einer Rückseite des Lichtquellenteils abgenommen zu werden, wobei
der Kasten so ausgebildet ist, dass er zu einer Seite des Befestigungsteils hin so vorsteht, dass er ein konkaves Verdrahtungsplatinenaufnahmeteil (24) zur Aufnahme der Verdrahtungsplatine in seiner Rückseite ausbildet, wobei
das Gehäuse so ausgebildet ist, dass es zu einer Seite der Lichtquelle hin derart vorsteht, dass es ein konkaves Leiterplattenaufnahmeteil zur Aufnahme der Leiterplatte in seiner Rückseite ausbildet und wobei
das Verdrahtungsplatinenaufnahmeteil und das Leiterplattenaufnahmeteil derart ausgebildet sind, dass die Verdrahtungsplatine und die Leiterplatte einander in einem Zustand nicht überlappend angeordnet sind, in dem das Befestigungsteil und das Lichtquellenteil derart angebracht sind, dass der Kasten des Lichtquellenteils und das Gehäuse des Befestigungsteils zusammengefügt sind.

2. Beleuchtungsvorrichtung nach Anspruch 1, bei der ein außerhalb des Verdrahtungsplatinenaufnahmeteils in dem Kasten ausgebildeter Abschnitt und das zu der Lichtquellenseite in dem Gehäuse hin vorragende Leiterplattenaufnahmeteil in einander entsprechenden Positionen so ausgebildet sind, dass sie im Zusammenwirken von Vorsprüngen und Vertiefungen zusammengefügt werden können.

3. Beleuchtungsvorrichtung nach Anspruch 2, bei der die Verdrahtungsplatine rahmenförmig ausgebildet ist und die Leiterplatte in einem mittigen Abschnitt des Befestigungsteils so angeordnet ist, dass die Leiterplatte mit einer zentralen Öffnung der rahmenförmigen Verdrahtungsplatine übereinstimmt.

## Revendications

1. Dispositif d'éclairage (1), comportant :
un moyen formant source de lumière (2) ayant un boîtier (20) pour loger un panneau luminescent et une carte de câblage (6) placée sur un côté surface non lumineuse du panneau luminescent ; et
un moyen de fixation (3) ayant un logement (30) pour recevoir une carte de circuit (8) servant à commander un allumage du panneau luminescent et conçu pour pouvoir être détaché d'un dos du moyen formant source de lumière, dans lequel
le boîtier est formé de manière à faire saillie vers un côté du moyen de fixation afin de constituer un moyen de réception (24) de carte de câblage concave pour recevoir la carte de câblage au dos de celui-ci,
le logement étant formé de manière à faire saillie vers un côté de la source de lumière afin de constituer un moyen de réception de carte de circuit concave pour recevoir la carte de circuit au dos de celui-ci, et
le moyen de réception de carte de câblage et le moyen de réception de carte de circuit étant conçus de façon que la carte de câblage et la carte de circuit soient agencés de manière à ne pas être amenées à se chevaucher lorsque le moyen de fixation et le moyen formant source de lumière sont fixés de façon que le moyen formant source de lumière et le logement du moyen de fixation soient assemblés l'un avec l'autre.

2. Dispositif d'éclairage selon la revendication 1, dans lequel une partie concave construite hors du moyen de réception de carte de câblage dans le boîtier et le moyen de réception de carte de circuit faisant saillie vers le côté source de lumière dans le logement sont respectivement formés dans des positions correspondantes afin d'être assemblés l'un avec l'autre par coopération de saillies et de creux.

3. Dispositif d'éclairage selon la revendication 2, dans lequel la carte de câblage est réalisée sous la forme d'un cadre et la carte de circuit est placée dans une partie centrale du moyen de fixation de façon que la carte de circuit corresponde à une ouverture centrale de la carte de câblage en forme de cadre.
